# EUROPÄISCHE PATENTANMELDUNG

(11) **EP 3 150 322 A1**
(43) Veröffentlichungstag der Anmeldung: **05.04.2017**
(21) Anmeldenummer: 15188085.3
(22) Anmeldetag: 02.10.2015
(51) Int. Cl.: B23K 20/12, F16K 51/02

(54) **VERSCHLUSSELEMENT FÜR EINE VAKUUMDICHTUNG MIT EINER REIBRÜHRSCHWEISSVERBINDUNG**

(71) Anmelder: VAT Holding AG, 9469 Haag (CH)
(72) Erfinder: BLECHA, Thomas, A-6800 Feldkirch (AT); GFELLER, Rudolf, CH-9475 Sevelen (CH); HOSSFELD, Max, CH-8953 Dietikon (CH)
(74) Vertreter: Kaminski Harmann

(57) **Zusammenfassung**

Verschlusselement für ein Vakuumventil mit einem Ventilteller (31) ausgebildet zum gasdichten Abschluss eines Prozessvolumens mittels Zusammenwirkens mit einer für das Prozessvolumen vorgesehenen Vakuumventilöffnung des Vakuumventils, wobei der Ventilteller (31) eine Verschlussseite (34) und eine hierzu im Wesentlichen parallel gegenüberliegenden Rückseite (33) und eine der Verschlussseite (34) zugeordnete und zu einer zweiten Dichtfläche der Vakuumventilöffnung, insbesondere hinsichtlich Form und Grösse, korrespondierende erste Dichtfläche (35) mit aufvulkanisiertem Dichtmaterial (36), wobei die zweite Dichtfläche die Vakuumventilöffnung umläuft, aufweist, sowie mit einem Querträger (40) mit einer Aufnahme für eine Antriebskomponente quer zu einer Erstreckungsrichtung des Querträgers, wobei der Querträger (40) an der Rückseite (33) des Ventiltellers (31) an zumindest einer Verbindungsstelle mit dem Ventilteller (31) verbunden ist. Die Verbindung des Querträgers (40) mit dem Ventilteller (31) weist an der zumindest einen Verbindungsstelle eine Reibrührschweissverbindung auf.

## Beschreibung

Die Erfindung betrifft ein Verschlusselement für ein Vakuumventil und ein ebensolches Ventil mit einem Ventilteller und einem an dem Ventilteller befestigten Querträger nach den Oberbegriffen der Ansprüche 1 und 10 sowie ein Verfahren zur Herstellung einer Verbindung zwischen dem Ventilteller und dem Querträger nach Anspruch 11 und ein mittels diesem Verfahren hergestelltes Produkt nach Anspruch 12.

Allgemein sind Vakuumventile zum im Wesentlichen gasdichten Schliessen eines Fliesswegs, der durch eine in einem Ventilgehäuse ausgeformte Öffnung führt, in unterschiedlichen Ausführungsformen aus dem Stand der Technik bekannt.

Vakuumschieberventile kommen insbesondere im Bereich der IC- und Halbleiterfertigung, die in einer geschützten Atmosphäre möglichst ohne das Vorhandensein verunreinigender Mikropartikel stattfinden muss, zum Einsatz. Beispielsweise durchlaufen in einer Fertigungsanlage für Halbleiter-Wafer oder Flüssigkristall-Substrate die hochsensiblen Halbleiter- oder Flüssigkristall-Elemente sequentiell mehrere Prozesskammern, in denen die innerhalb der Prozesskammer befindlichen Halbleiterelemente mittels jeweils einer Bearbeitungsvorrichtung bearbeitet werden. Sowohl während des Bearbeitungsprozesses innerhalb der Prozesskammer, als auch während des Transports von Prozesskammer zu Prozesskammer müssen sich die hochsensiblen Halbleiterelemente stets in geschützter Atmosphäre - insbesondere im Vakuum - befinden.

Die Prozesskammern sind beispielsweise über Verbindungsgänge miteinander verbunden, wobei die Prozesskammern mittels Vakuumschieberventile zum Transfer der Teile von der einen zur nächsten Prozesskammer geöffnet und im Anschluss zur Durchführung des jeweiligen Fertigungsschritts gasdicht verschlossen werden können. Derartige Ventile werden aufgrund des beschriebenen Anwendungsgebiets auch als Vakuum-Transferventile und aufgrund ihres rechteckigen Öffnungsquerschnitts auch als Rechteckschieber bezeichnet.

Da Transferventile unter anderem bei der Herstellung hochsensibler Halbleiterelemente zum Einsatz kommen, muss die insbesondere durch die Betätigung des Ventils und durch die mechanische Belastung des Ventilverschlussgliedes verursachte Partikelgenerierung und die Anzahl der freien Partikel im Ventilraum möglichst gering gehalten werden. Die Partikelgenerierung ist primär eine Folge von Reibung beispielsweise durch Metall-Metall-Kontakt und durch Abrasion.

Abhängig von den jeweiligen Antriebstechnologien wird insbesondere zwischen Schieberventilen, auch Ventilschieber oder Rechteckschieber genannt, und Pendelventilen unterschieden, wobei das Schliessen und Öffnen im Stand der Technik meistens in zwei Schritten erfolgt. In einem ersten Schritt wird ein Ventilverschlussglied, insbesondere ein Verschlussteller, im Falle eines Schieberventils, wie beispielsweise aus der US 6,416,037 (Geiser) oder der US 6,056,266 (Blecha) bekannt, insbesondere des L-Typs, linear über eine Öffnung im Wesentlichen parallel zum Ventilsitz verschoben oder im Falle eines Pendelventils, wie beispielsweise aus der US 6,089,537 (Olmsted) bekannt, um eine Schwenkachse über die Öffnung geschwenkt, ohne dass hierbei eine Berührung zwischen dem Verschlussteller und dem Ventilsitz des Ventilgehäuses stattfindet. In einem zweiten Schritt wird der Verschlussteller mit dessen Verschlussseite auf den Ventilsitz des Ventilgehäuses gedrückt, so dass die Öffnung gasdicht verschlossen wird. Die Abdichtung kann z.B. entweder über eine auf der Verschlussseite des Verschlusstellers angeordnete Dichtung, die auf den die Öffnung umlaufenden Ventilsitz gepresst wird, erfolgen, oder über einen Dichtungsring auf dem Ventilsitz, gegen den die Verschlussseite des Verschlusstellers gedrückt wird. Die Dichtung insbesondere der Dichtungsring, kann in einer Nut gehalten und/oder aufvulkanisiert sein.

Unterschiedliche Dichtvorrichtungen sind aus dem Stand der Technik bekannt, beispielsweise aus der US 6,629,682 B2 (Duelli). Ein geeignetes Material für Dichtungsringe und Dichtungen bei Vakuumventilen ist beispielsweise Fluorkautschuk, auch FKM genannt, insbesondere das unter dem Handelsnamen Viton® bekannte Fluorelastomer, sowie Perfluorkautschuk, kurz FFKM.

Die beschriebene zweistufige Bewegung, bei welcher das Verschlussglied zuerst quer über die Öffnung geschoben wird, ohne dass es zu einer Berührung der Dichtung mit dem Ventilsitz kommt, und das Verschlussglied im Anschluss im Wesentlichen senkrecht auf den Ventilsitz gedrückt wird, hat neben der Möglichkeit einer präzisen Regelung des Durchflusses vor allem den Vorteil, dass die Dichtung nahezu ausschliesslich senkrecht verpresst wird, ohne dass es zu einer Quer- oder Längsbelastung der Dichtung kommt. Hierfür kommt entweder ein einziger Antrieb, der eine L-förmige Bewegung des Verschlussglieds ermöglicht, oder eine Mehrzahl an Antrieben, beispielsweise zwei Linearantrieben oder einem Linear- und einem Spreizantrieb, zum Einsatz.

Ausserdem sind Schieberventile bekannt, bei welchen der Schliess- und Dichtvorgang zwar über eine einzige lineare Bewegung erfolgt, jedoch die Dichtgeometrie derart ist, dass eine Querbeanspruchung der Dichtung gänzlich vermieden wird. Ein solches Ventil ist beispielsweise das unter der Produktbezeichnung "MONOVAT Reihe 02 und 03" bekannte und als Rechteckinsertventil ausgestaltete Transferventil der Firma VAT Vakuumventile AG in Haag, Schweiz. Der Aufbau und die Funktionsweise eines solchen Ventils werden beispielsweise in der US 4,809,950 (Geiser) und der US 4,881,717 (Geiser) beschrieben.

Das dort beschriebene Ventil besitzt in seinem Gehäuse eine Dichtfläche, die, in Richtung der Achse der Ventildurchgangsöffnung gesehen, hintereinander liegende Abschnitte besitzt, die in seitlich nach aussen verlaufende, ebene Dichtflächenabschnitte über stetig verlaufende Krümmungen übergehen, wobei die gedachten Erzeugenden dieser einteiligen, aber mehrere Abschnitte aufweisenden Dichtfläche parallel zur Achse der Ventildurchgangsöffnung liegen.

Ein geeigneter Antrieb für ein solches, mittels einer linearen Bewegung verschliessbares Transferventil ist in der JP 6241344 (Buriida Fuuberuto) dargestellt. Der dort beschriebene Antrieb besitzt exzentrisch gelagerte Hebel zum linearen Verschieben der Schubstangen, auf welchen das Verschlussglied montiert ist.

In einer verbreiteten Ausführungsform der oben genannten Ventiltypen sind das Verschlussglied und der Ventilantrieb über mindestens einen Verstellarm, insbesondere eine Schubstange oder Ventilstange, verbunden. Hierbei ist der starre Verstellarm mit seinem einen Ende starr mit dem Verschlussglied und mit seinem anderen Ende starr mit dem Ventilantrieb verbunden. Der Verschlussteller ist bei den meisten Ventilen mittels Verschraubung mit der mindestens einen Schubstange verbunden.

In der CH 699 258 B1 wird ein Vakuumventil mit einem Verschlussteller beschrieben, in welchem mindestens eine Stangenaufnahme ausgeformt ist, und mindestens einer Schubstange, an welcher der Verschlussteller über einen in die Stangenaufnahme eingreifenden Verbindungsabschnitt der Schubstange abnehmbar montiert ist. Die Stangenaufnahme ist als ein Sackloch ausgebildet, in welches die Schubstange mit ihrem Verbindungsabschnitt eingeführt ist. Der Verschlussteller weist ein in das Sackloch verstellbar hineinragendes und derart ausgebildetes Klemmelement auf, dass eine durch das Verstellen des Klemmelements lösbare Klemmverbindung zwischen dem Verschlussteller und dem Verbindungsabschnitt besteht. Ein partikeldichtender Dichtring ist zwischen dem Sackloch und der Schubstange derart angeordnet, dass durch die Klemmverbindung erzeugte Partikel am Austreten aus dem Sackloch gehindert werden, wodurch die Anzahl ungewollter, durch Materialreibung verursachter Partikel im Ventilraum gering gehalten und eine schnelle und komfortable Montierbarkeit und Demontierbarkeit des Verschlusstellers auf der mindestens einen Schubstange ermöglicht wird.

In der DE 10 2008 061 315 B4 wird eine Aufhängung einer Ventilplatte an einer Ventilstange mittels einem quer zur Ventilstange sich erstreckenden Querträger beschrieben. Der Querträger ist an einer mittleren Verbindungsstelle mit der Ventilstange insbesondere durch eine Schraube verbunden und an mindestens zwei beidseitig zu der mittleren Verbindungsstelle liegenden seitlichen Verbindungsstellen mit der Ventilplatte, insbesondere mittels Verschraubung, verbunden. Der Querträger weist in einem mittleren Abschnitt, der die mittlere Verbindungsstelle und beidseitig an diese anschließende Abschnitte des Querträgers umfasst, einen Abstand von der Ventilplatte auf. Mittels dieser einfach ausgebildeten Aufhängung wird eine gewisse Verschwenkung, beispielsweise im Bereich von 1°, der Ventilplatte gegenüber der Ventilstange um eine rechtwinkelig zur Ventilstange stehende Schwenkachse durch eine Verwindung des Querträgers ermöglicht. Es kann dadurch eine sehr einfache Ausbildung erreicht werden. Der Querträger kann vorzugsweise materialeinstückig und insbesondere vollständig aus Metall ausgebildet sein.

In der US 6 471 181 B2 wird eine ähnliche Aufhängung beschrieben. Ein mit der Ventilstange zu verbindender Querträger umfasst eine erste Platte, die eine konische Öffnung zur Aufnahme des Endes der Ventilstange aufweist, die mit der ersten Platte verschraubt wird. Beidseitig zu der mittleren Verbindungsstelle mit der Ventilstange sind an der ersten Platte elastische Lagerblöcke angebracht, an deren der ersten Platte gegenüberliegenden Seiten zweite Platten angebracht sind, welche jeweils mit der Ventilplatte verschraubt werden. Mittels dieser elastischen Lagerblöcke wird eine Verkippung um eine rechtwinkelig zur Ventilstange stehende Achse ermöglicht, sodass eine gleichmäßigere Anpressung der Dichtung der Ventilplatte am Ventilsitz erreicht wird.

In der US 2008/0066811 A1 wird ein Vakuumventil beschrieben, bei welchem eine Ventilplatte mit ersten und zweiten Querträgern verbunden ist. Die Querträger sind mit der Ventilplatte über Verbindungsglieder verbunden. Diese weisen von einer Verbindungsstelle mit dem Querträger beidseitig in Längsrichtung des Querträgers sich erstreckende Verbindungsarme auf, die endseitig mit einem gemeinsamen in Längsrichtung des Querträgers sich erstreckenden Verbindungsschenkel verbunden sind, welcher an mehreren in Längsrichtung des Querträgers beabstandeten Stellen an der Ventilplatte angeschraubt ist. Hierdurch soll eine gleichmäßigere Kraftübertragung in Längsrichtung der Querträger erreicht werden.

Gemein ist diesen Ausführungsformen, dass ein jeweiliger Ventilteller mit dem entsprechenden Querträger mittels mehrerer Schraubungen, welche insbesondere auch innerhalb des Vakuumbereichs vorliegen, verbunden ist.

Schraubverbindungen innerhalb eines Vakuumbereichs bergen die Gefahr eines so genannten virtuellen inneren Vakuumlecks, da gewissen Teile des Gewindes der Verschraubung beim Evakuieren des Ventilinnenraums mehr oder weniger luftdicht von der restlichen Umgebung abgeschlossen sind und somit das teilweise im Gewinde verbliebene Gas nach dem Evakuieren langsam entweicht und den Ventilinnenraum kontaminiert. Aus diesem Grunde werden im Stand der Technik in die Gewindeabschnitte führende Verbindungskanäle und -schlitze geschaffen, wodurch die Gewinde belüftet werden. Somit kann beim Evakuieren kein Gas im Gewinde verbleiben.

In anderen Worten werden bei Vakuumventilen bewusst Massnahmen getroffen, um allfällig innerhalb des Vakuumbereichs eines Vakuumventils befindliche inneren Gasbereiche, die von dem Vakuumbereich umschlossen sind, zu vermeiden, indem diese inneren Gasbereiche insbesondere mittels Belüftungsbohrungen belüftet und somit mit dem Vakuumbereich verbunden werden. Im Falle von Schraubverbindungen erfolgt dies mittels der beschriebenen Verbindungskanäle oder -schlitze oder auch Bohrungen in einer Schraube.

Diese bewusste Gewindebelüftung ist bei Schraubverbindungen innerhalb eines Vakuumbereichs bei Vakuumventilen bekannt und findet bei auf den Markt befindlichen Ventiltypen bereits Anwendung.

Es hat sich jedoch herausgestellt, dass diese zur Vermeidung virtueller innerer Vakuumlecks bewusst geschaffene Gewindebelüftung vor allem bei gewollten oder ungewollten, minimalen Relativbewegungen zwischen den mittels der Verschraubung verbundenen Teile von gewissem Nachteil sein kann, da innerhalb des Gewindes kleine Reibpartikel in Form von Mikropartikeln entstehen, welche durch die Belüftungskanäle oder -schlitze entweichen und das Ventilinnere verunreinigen. Solche Partikel können nicht nur im Gewinde, sondern an anderen Kontaktstellen einer Schraube entstehen. Dies ist vor allem bei Metallgewinden der Fall. Hierdurch kommt es zu einer negativen Beeinfussung des Fertigungsprozesses. Bei üblichen Schraubverbindungen im Vakuumbereich ist die Relativbewegung der Gewindeteile jedoch derart gering, dass bisher eine Partikelerzeugung als vernachlässigbar betrachtet wurde.

Bei gewissen Verbindungsarten ist eine Relativbewegung im Gewinde jedoch unvermeidbar. Eine solche Relativbewegung im Gewinde und einer daraus resultierenden Partikelerzeugung kann insbesondere bei dem oben beschriebenen, in der DE 10 2008 061 315 B4 offenbarten Ventiltyp entstehen, da es bei diesem Ventil bewusst zu einer elastischen Verformung des Querträgers zur Ermöglichung einer Schwenkbewegung um die gedachte Schwenkachse kommt.

Generell bergen Schraubverbindungen innerhalb eines Vakuumbereichs eines Vakuumventils die Gefahr der Erzeugung ungewollter, prozessschädigender Reibpartikel in Form von Mikropartikeln, die durch eine Relativbewegung zwischen den Gewinden entstehen.

Es ist daher Aufgabe der Erfindung, ein Verschlusselement für ein Vakuumventil oder ein Vakuumventil mit einem mechanisch gekoppelten zweiten Bauteil, insbesondere Querträger, bereitzustellen, wobei die Anzahl von erzeugten Reibpartikel innerhalb des Vakuumbereichs vermieden oder gering gehalten wird.

Diese Aufgabe wird durch die Verwirklichung der Merkmale der unabhängigen Ansprüche gelöst. Merkmale, die die Erfindung in alternativer oder vorteilhafter Weise weiterbilden, sind den abhängigen Patentansprüchen zu entnehmen.

Der Erfindung liegt die Idee zugrunde, anstelle einer Verschraubung zur Befestigung des Querträgers an einem Ventilteller für ein Vakuumventil eine Schweissverbindung vorzusehen und zwar eine spezielle Verschweissung in Form einer Reibrührschweissverbindung (FSW-Verbindung, FSW = Friction Stir Welding). Diese Methode ist insbesondere deshalb vorteilhaft, da hierbei keinerlei weitere Schweissmaterialien benötigt werden, da eine Materialumformung unterhalb des jeweiligen Schmelzpunktes erfolgen kann und somit die strukturellen Anforderungen an die zu produzierenden Teile weitgehend unbeeinträchtigt bleiben können und da vergleichsweise wenige bzw. keine Materialabriebe entstehen. Zudem ist die so herstellbare Verbindung sehr robust und belastbar. Insbesondere durch die damit ermöglichte Vermeidung von Partikelrückständen in dem Verbindungsbereich wird eine deutliche Verbesserung hinsichtlich möglicher Quellen für Verunreinigungen innerhalb des Vakuumbereichs erreicht.

Die Erfindung betrifft ein Verschlusselement für ein Vakuumventil mit einem Ventilteller, welcher ausgebildet ist zum gasdichten Abschluss eines Prozessvolumens mittels Zusammenwirkens mit einer für das Prozessvolumen vorgesehenen Vakuumventilöffnung des Vakuumventils. Der Ventilteller verfügt über eine (insbesondere dem Prozessvolumen zugewandte) Verschlussseite und eine hierzu im Wesentlichen parallel gegenüberliegenden Rückseite und über eine der Verschlussseite zugeordnete und zu einer zweiten Dichtfläche der Vakuumventilöffnung, insbesondere hinsichtlich Form und Grösse, korrespondierende erste Dichtfläche mit insbesondere aufvulkanisiertem Dichtmaterial, wobei die zweite Dichtfläche die Vakuumventilöffnung umläuft. Das Verschlusselement hat zudem einen Querträger mit einer Aufnahme für eine Antriebskomponente, z.B. Ventilstange, quer zu einer Erstreckungsrichtung des Querträgers, wobei der Querträger an der Rückseite des Ventiltellers an zumindest einer Verbindungsstelle mit dem Ventilteller verbunden ist.

Der Querträger dient wie bereits beschrieben beispielsweise der Anbindung einer Antriebsstange und/oder einer Stabilisierung (Vorspannung) des Ventiltellers.

Erfindungsgemäss weist die Verbindung des Querträgers mit dem Ventilteller an der zumindest einen Verbindungsstelle eine Reibrührschweissverbindung auf.

Die Reibrührschweissverbindung wird hierzu durch ein im Wesentlichen (allein) vertikales Führen (im Wesentlichen orthogonal zur Oberfläche des Ventiltellers bzw. des Querträgers) eines Schweisswerkzeugs derart, dass das Werkzeug sowohl Material des Querträgers als auch des Ventiltellers verformbar macht (plastifiziert).

Gemäss einer Ausführungsform verfügt das Verschlusselement über mehr als eine Verbindungsstelle, also über mehrere Stellen an denen eine Anbindung des Querträgers an den Ventilteller realisiert ist. Der Querträger ist dann vorzugsweise mittels zweier Verbindungsstellen mit der Rückseite des Ventiltellers verbunden ist, wobei die zwei Verbindungen mittels jeweils einer Reibrührschweissverbindung ausgebildet sind.

Der Querträger weist gemäss einer weiteren Ausfügungsform die Aufnahme für die Antriebskomponente mittig an dem Querträger auf, wobei die z.B. beiden Verbindungsstellen beidseitig relativ zu der Aufnahme liegend angeordnet sind.

Die Reibrührschweissverbindung kann insbesondere von Seiten der Verschlussseite des Ventiltellers oder ausgehend von der Oberseite des Querträgers ausgeformt sein. An der jeweiligen Seite von welcher ein entsprechendes Reibrührschweisswerkzeug zur Herstellung der Verbindung angesetzt wird, bleibt am Werkstück eine Vertiefung bestehen.

Das Reibrührschweisswerkzeug, z.B. ein aus einer Schulter herausragender Stift, wird insbesondere orthogonal zu einer Erstreckungsrichtung des Ventiltellers (orthogonal zur Oberfläche der Verschluss- oder Rückseite) oder des Querträgers bewegt. Dabei wird der Stempel (Werkzeug) unter Rotation auf bzw. in das Material des Tellers oder Trägers gedrückt, wodurch dessen Material plastifiziert (verformbar) wird. Durch ein Weiterbewegen (Drücken) des Werkzeugs in diese Richtung wird in Folge auch die zweite Komponente erreicht und deren Material plastifiziert. Durch das anhaltende Rotieren des Werkzeugs werden die Materialen der beiden Komponenten im plastifizierten Zustand ineinander verrührt, wodurch ein Stoffschluss erzeugt wird. Das Werkzeug wird in Folge in entgegengesetzter Richtung vom Verschlusselement entfernt. Der Stoffschluss, d.h. die Schweissverbindung, bleibt erhalten.

In Abhängigkeit einer gewünschten Grösse oder gewollten Stabilität der Verbindung kann das gesamte Werkzeug beispielsweise in einer Kreis- oder Spiralbewegung geführt werden, während dies zu verbindenden Materialien bereits plastifiziert vorliegen. Dadurch kann ein entsprechend grösserer Bereich erzeugt werden, in dem ein Stoffschluss aus beiden Materialien vorliegt.

Gemäss einer spezifischen Ausführungsform weist das Verschlusselement an der mindestens einen Verbindungsstelle eine Vertiefung auf, die sich im Wesentlichen parallel zu einer Achse erstreckt, die orthogonal zu einer durch die Form oder Oberfläche der Rückseite oder Verschlussseite definierten Ebene steht.

Die Öffnung der Vertiefung liegt insbesondere seitens des Querträgers vor. In dieser Ausführung ist die Reibrührschweissverbindung von Seiten des Querträgers erzeugt worden. Die Oberfläche der Verschlussseite des Ventiltellers weist hierbei keinerlei strukturelle Veränderung auf.

Gemäss einer weiteren Ausführungsform kann das Verschlusselement eine der mindestens einen Verbindungsstelle zugeordnete Vertiefung verschlussseitig aufweisen, wobei sich die Vertiefung im Wesentlichen parallel zu besagter Achse erstreckt. In anderen Worten, die Vertiefung ist zur Verschlussseite hin geöffnet.

Gemäss einer Ausführungsform der Erfindung erstreckt sich die Vertiefung über eine definierte Tiefe in Richtung besagter Achse, wobei die Tiefe grösser ist als eine Materialdicke des Querträgers bzw. des Ventiltellers an der Verbindungsstelle. Ist die Vertiefung zum Ventilteller hin geöffnet, ist die Tiefe der Vertiefung grösser als die Dicke des Tellers an dieser Stelle, ist die die Vertiefung zum Querträger hin geöffnet, ist die Tiefe der Vertiefung grösser als die Dicke des Querträgers an dieser Stelle.

Insbesondere ist die Vertiefung seitens des Querträgers derart ausgeformt, dass die Vertiefung sich durch den Querträger hindurch erstreckt und in den Ventilteller hinein ragt.

Alternativ ist die Vertiefung seitens des Ventiltellers derart ausgeformt, dass die Vertiefung sich durch den Ventilteller hindurch erstreckt und in den Querträger hinein ragt.

Durch beide obigen Varianten ist eine Verrührung der Materialen von Querträger und Ventilteller in gewünschter Weise erzeugt, d.h. so dass Teile beider Komponenten plastifiziert und verbunden wurden.

Gemäss einer Ausführungsform der Erfindung liegt an der Verbindungsstelle in einem Übergangsbereich ein durch zeitweises Plastifizieren der Materialien des Querträgers und des Ventiltellers erzeugter Stoffschluss vor, wobei der Übergangsbereich durch einen sich entlang der Achse über einen Kontaktpunkt des Querträgers mit dem Ventilteller erstreckenden Abschnitt an der Verbindungsstelle definiert ist.

Die Reibrührschweissverbindung kann zudem einen homogenen Materialübergang zwischen dem Ventilteller und dem Querträger bereitstellen, d.h. entlang einer Richtung in welche das Verbindungswerkzeug (z.B. rotierender Stift) zur Herstellung der Verbindung in die Materialien der zu verbindenden Komponenten hinein bewegt bzw. gedrückt wird. Insbesondere wird dabei eine spaltfreie Verbindung der beiden Teile erzeugt und bereitgestellt.

Die Erfindung betrifft zudem ein Vakuumventil zum gasdichten Abschluss eines Prozessvolumens, mit einem Ventilgehäuse, das eine Vakuumventilöffnung und einen die Vakuumventilöffnung umlaufenden eine zweite Dichtfläche aufweisenden Ventilsitz aufweist, und mit einem Ventilteller zum im Wesentlichen gasdichten Verschliessen der Vakuumventilöffnung mit einer ersten zu der zweiten Dichtfläche korrespondierenden Dichtfläche. Das Vakuumventil weist zudem einen Querträger mit einer Aufnahme für eine Antriebskomponente (z.B. Ventilstange) quer zu einer Erstreckungsrichtung des Querträgers auf, wobei der Querträger an einer Rückseite des Ventiltellers an zumindest einer Verbindungsstelle mit dem Ventilteller verbunden ist. Ferner verfügt das Vakuumventil über eine mit dem Querträger vermittels der Aufnahme gekoppelte Antriebseinheit, die derart ausgebildet ist, dass der Ventilteller von einer Offenposition, in welcher der Ventilteller die Vakuumventilöffnung freigibt, in eine Schliessposition, in welcher die erste Dichtfläche des Ventiltellers auf die zweite Dichtfläche angedrückt ist und die Vakuumventilöffnung im Wesentlichen gasdicht verschliesst, und zurück verstellbar ist, insbesondere zumindest im Wesentlichen entlang einer geometrischen Längsachse in eine Längsschliessrichtung verstellbar ist. Insbesondere kann durch eine Beweglichkeit des Ventiltellers im Wesentlichen entlang einer rechtwinklig zur Längsachse verlaufenden geometrischen Querachse in eine Querschliessrichtung dieser in eine Zwischenposition, in welcher der Ventilteller die Vakuumventilöffnung überdeckt und sich eine Verschlussseite des Ventiltellers in einer beabstandeten Gegenüberlage zum Ventilsitz befindet, und zurück verstellbar sein.

Erfindungsgemäss weist die Verbindung des Querträgers mit dem Ventilteller an der zumindest einen Verbindungsstelle eine Reibrührschweissverbindung auf, insbesondere wobei ein den Ventilteller und den Querträger aufweisendes Verschlusselement nach einem der obigen Ansätze ausgebildet ist.

Die Erfindung betrifft ausserdem ein Verfahren zur Herstellung eines Verschlusselements mit einem Querträger für ein Vakuumventil, mit einem körperlichen ersten Teil und einem ebenso strukturellen zweiten Teil, wobei das erste Teil und das zweite Teil jeweils entweder einen Ventilteller oder den Querträger verkörpern. Das erste Teil verkörpert also den Ventilteller des Verschlusselements und das zweite Teil den Querträger des Verschlusselements, oder umgekehrt.

Ein Fügewerkzeug wird mit dem ersten und dem zweiten Teil bestückt. Das bestückte Fügewerkzeug wird in eine Fügemaschine, insbesondere in eine Schweissmaschine, eine Werkzeugmaschine (Bearbeitungszentrum) oder eine Fräsmaschine, insbesondere Reibrührschweissmaschine, eingebracht. Durch Zusammenwirken der Fügemaschine mit dem ersten und zweiten Teil wird eine Reibrührschweissverbindung des Querträgers mit dem Ventilteller hergestellt.

Beispielsweise wird ein Reibrührschweisswerkzeug in z.B. Form eines Stifts wird mittels der Maschine in Rotation versetzt. Der Stift wird dann an der gewünschten Verbindungsstelle auf eine Seite des Verschlusselements gedrückt. Die Bewegung des Werkzeugs in Richtung der Materialdicke der zu verbindenden Teile wird solange weitergeführt, bis eine Plastifizierung des Materials an dieser Stelle beider Komponenten eingesetzt hat bzw. vorliegt und die Materialien ineinander verrührt sind. Damit liegt nach Entfernen des Werkzeugs und Abkühlen der Fügestelle ein dauerhafter Stoffschluss vor.

In anderen Worten erfolgt das Fügen der beiden Komponenten insbesondere wie folgt: die Fügemaschine weist ein Verbindungswerkzeug, insbesondere einen aus einer Schulter herausragenden Stift, auf, das Verbindungswerkzeug wird mittels der Fügemaschine in Rotation um eine lineare Bewegungsachse versetzt, insbesondere konzentrisch um eine Längsachse des Verbindungswerkzeugs, und das rotierende Verbindungswerkzeug wird entlang der Bewegungsachse derart tief in das erste Teil gedrückt wird, dass das Verbindungswerkzeug das erste Teil hinsichtlich dessen Dicke in Richtung der Bewegungsachse durchdringt und das Verbindungswerkzeug in den Körper des zweiten Teils eindringt.

Gemäss einer Ausführungsform wird das Verbindungswerkzeug in einem plastisch verformbaren Zustand des Materials des ersten Teils und des Materials des zweiten Teils orthogonal zur Bewegungsachse entlang einer definierten Trajektorie geführt, insbesondere kreisförmig oder spiralförmig in einer Ebene orthogonal zur Bewegungsachse. Durch eine solche orthogonale Relativbewegung (orthogonal zur Längsachse des das Verbindungswerkzeug verkörpernden Stifts) kann eine spaltfreie Verbindung der beiden Teile (Ventilteller und Querträger) verlässlich hergestellt werden. Eine derartige Spaltfreiheit ist insbesondere für Bauteile und Anwendungen in der Vakuumtechnik von grossem Vorteil (hinsichtlich der Vermeidung von Partikeln).

Ausserdem betrifft die Erfindung ein Verschlusselement, welches durch Ausführung eines oben beschriebenen Verfahrens erhalten wird, insbesondere wobei ein Verschlusselement gemäss der Erfindung ist.

Das erfindungsgemässe Verfahren und die erfindungsgemässe Vorrichtung werden nachfolgend anhand von in den Zeichnungen schematisch dargestellten konkreten Ausführungsbeispielen rein beispielhaft näher beschrieben, wobei auch auf weitere Vorteile der Erfindung eingegangen wird. Im Einzelnen zeigen:
- Figs. 1a-b: eine Ausführungsform eines Verschlusselements und eines Vakuumventils nach dem Stand der Technik;
- Fig. 2: einen Teil eines Verschlusselements gemäss der Erfindung;
- Fig. 3: einen Ventilteller, welcher mit einem Querträger verbunden ist, in einer Querschnittsansicht durch die Verbindungsstelle;
- Figs. 4a-b: jeweils ein Verschlusselement gemäss der Erfindung in einem getrennten Zustand und in einem nach einem Reibrührscheissverbinden vorliegenden verbundenen Zustand in einer Querschnittsansicht;
- Fig. 5: eine weitere Ausführungsform eines Teils eines Verschlusselements gemäss der Erfindung;
- Fig. 6: eine weitere Ausführungsform eines Verschlusselements mit einem auf einem Ventilteller angebrachten Querträger gemäss der Erfindung;
- Fig. 7: ein Fügeverfahren zur Verbindung eines Ventiltellers mit einem Querträger gemäss der Erfindung; und
- Figs. 8a-b: Trajektorien zur erfindungsgemässen Führung eines Verbindungswerkzeugs zur Herstellung einer Reibrührschweissverbindung gemäss der Erfindung.

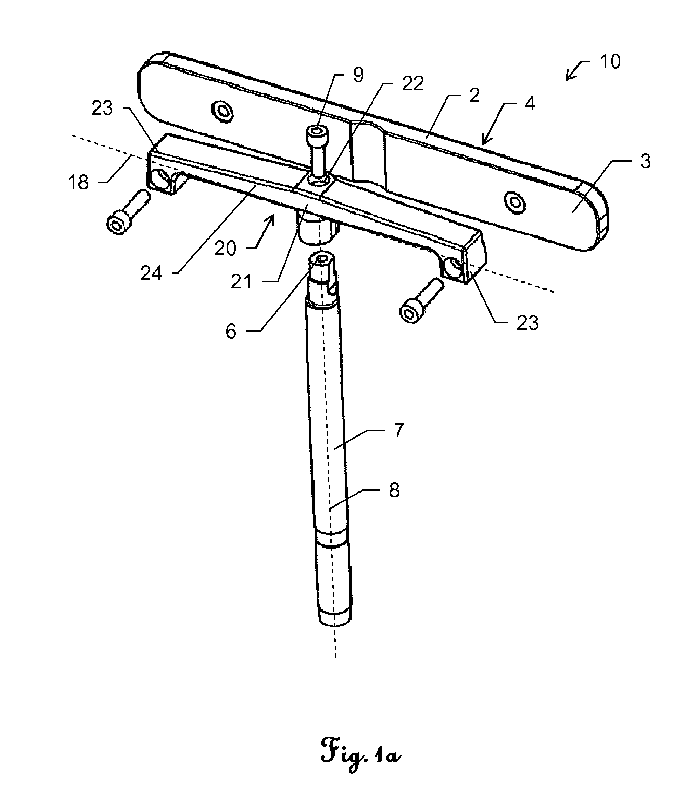

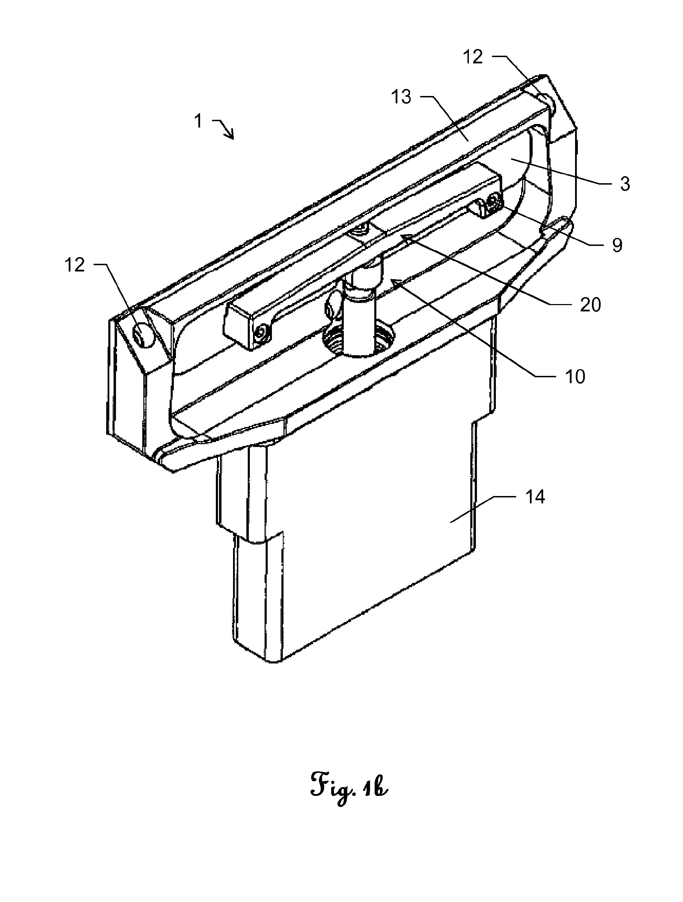

In den Figuren 1a und 1b sind in Form einer Ausführungsform des Standes der Technik ein Verschlussglied 2 (Ventilteller) und ein Verstellarm 7 mit einem Querträger 20 dargestellt. Der sich quer zu einer Verstellachse 8 erstreckende Querträger 20 ist an einer Verbindungsstelle 21 mit dem Verstellarm 7 verbunden. Diese Verbindungsstelle 21 weist eine Schraube 9 auf, die durch eine Zylindersenkung 22 und ein Durchgangsloch des Querträgers 20 hindurchgeführt ist und in ein in einem Sackloch 6 ausgeformten Gewinde im Verstellarm 7 eingreift.

Der Querträger 20 ist auf der Rückseite 3 des Verschlussgliedes 2, die der Verschlussfläche 4 gegenüberliegt, an zwei beidseitig zu der mittleren Verbindungsstelle 21 liegenden seitlichen Verbindungsstellen 23 mit dem Verschlussglied 2 verbunden. Diese seitlichen Verbindungsstellen 23 weisen jeweils eine Schraube 9 auf, die jeweils durch ein in dem Querträger 20 ausgeformtes Durchgangsloch mit Zylindersenkung hindurchgeführt ist und in ein auf der Rückseite 3 des Verschlussgliedes 2 ausgeformtes Gewinde in einem Sackloch eingreift. Somit bildet der Querträger 20 abstrakt ein erstes Bauteil und das Verschlussglied 2 abstrakt ein zweites Bauteil eines Verschlusselements 10.

In einem mittleren Abschnitt 24, der die mittlere Verbindungsstelle 21 und beidseitig an diese anschliessende Abschnitte umfasst und der sich zwischen den seitlichen Verbindungsstellen 23 erstreckt, weist der Querträger 20 einen definierten Abstand von der Rückseite 3 auf. In anderen Worten ist der Querträger 20 in dem mittleren Abschnitt 24 beanstandet zur Rückseite 3 angeordnet und berührt das Verschlussglied 2 in diesem Bereich nicht. In anderen Worten überspannt der Querträger 20 die Rückseite 3 des Verschlussgliedes 2 und liegt ausschliesslich im Bereich der seitlichen Verbindungsstellen 23 auf der Rückseite 3 des Verschlussgliedes 2 auf.

Der einstückig aus Metall ausgebildete Querträger 20 ist derart elastisch ausgebildet, dass das Verschlussglied 2 durch eine Verwindung des Querträgers 20 relativ zu dem Verstellarm 7 um eine rechtwinklig zu der Verstellachse 8 stehende Schwenkachse 18, die parallel zu einer Ventilöffnung und dem Ventilsitz verläuft, verschwenkbar ist.

Das Vakuumventil 1 weist zudem zwei Ventilbefestigungslöcher 12 in der Wand 13 auf, mittels welcher die mit dem Gehäuse der Antriebseinheit 14 gekoppelte Wand 13 an einer Komponente, insbesondere an einer Vakuumkammer, montiert werden kann. Auch diese Befestigung kann mittels einer Schraubverbindung erfolgen.

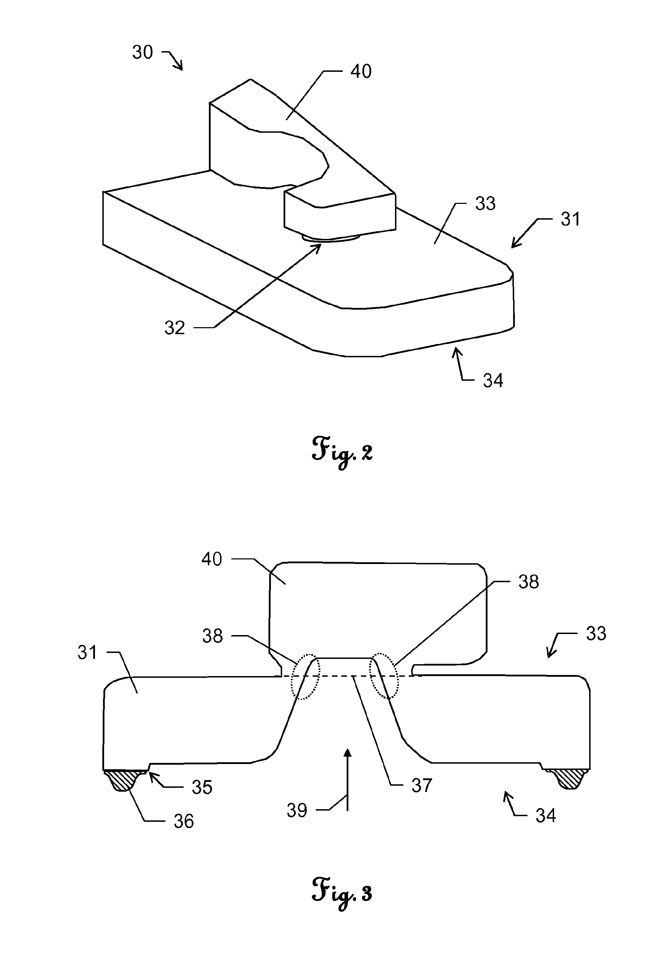

Figur 2 zeigt einen Teil eines Verschlusselements 30 gemäss der Erfindung. Das Verschlusselement 30 weist einen Ventilteller 31 und einen mit der Rückseite 33 des Ventiltellers 31 verbundenen Querträger 40 auf. Die Verbindung zwischen dem Ventilteller 31 und dem Querträger 40 ist mittels einer Reibrührschweissverbindung hergestellt. Gezeigt ist hier eine Verbindungsstelle 32 von beispielsweise insgesamt zwei Verbindungsstellen des Verschlusselements 30.

Die Reibrührschweissverbindung wurde von Seiten der Verschlussseite 34 des Ventiltellers 31 erzeugt, so dass der Querträger 40 an der Verbindungsstelle keinerlei Vertiefung oder ähnliche Oberflächenauffälligkeiten ausweist. Eine detaillierte Darstellung ist in Zusammenhang mit Figur 3 zu finden.

Figur 3 zeigt einen Ventilteller 31, welcher mit einem Querträger 40 verbunden ist, in einer Querschnittsansicht durch die Verbindungsstelle. Die gestrichelte Linie 37 verdeutlicht die vor dem Verbindungsvorgang vorhandene strukturelle Grenze zwischen dem von dem Ventilteller 31 getrennten Querträger 40.

Bei dem Verbinden der beiden Teile (Querträger 40 und Ventilteller 31) mittels des Fügeverfahrens des Reibrührschweissens wird ein rotierender Stift oder Stempel mit grossem Druck in Richtung des gezeigten Pfeils 39 auf die Verschlussseite 34 gedrückt. Dadurch wird das Material, hier vorzugsweise Metall oder eine Metalllegierung, zunächst nur des Ventiltellers 31 unter Wärmeentwicklung plastifiziert, d.h. von einem festen Zustand in einen verformbaren oder fliessfähigen Zustand gebracht. Der rotierende Stempel wird soweit in Richtung des Pfeils 39 weiter bewegt bzw. gedrückt, dass dadurch im Folgenden auch das Material des Querträgers 40 im Bereich der Verbindungsstelle plastifiziert wird. Somit liegt dann sowohl das Material des Querträgers 40 als auch das des Ventiltellers 31 plastisch verformbar vor.

Durch die Rotationsbewegung des Reibrührwerkzeugs (Stift, Stempel etc.) werden die in diesem plastischen Zustand vorliegenden Materialen der beiden Teile ineinander verrührt. Damit entsteht in den beiden Bereichen 38 eine Verbindung der Materialien. Dieser Vorgang erfolgt typischerweise bei Temperaturen unterhalb der Schmelzpunkte der beiden Materialen. Vorteilhaft ist hierbei ausserdem, dass dabei eine hohe statische und dynamische Verbindung hergestellt wird und keine Materialspritzer oder Rauch entstehen. Auch wird kein zusätzliches Schweissmaterial, wie z.B. Schweissdraht, benötigt.

Nach Entfernen des Reibrührwerkzeugs verbleibt eine von der Verschlussseite 34 sich über die gesamte Dicke des Ventiltellers 31 an der Verbindungsstelle erstreckende und in den Querträger 40 hineinragende Vertiefung wie gezeigt zurück. Der Querträger 40 ist somit an der Rückseite 33 des Ventiltellers 31 befestigt.

In dem Ventilteller 31 kann bereits verschlussseitig eine Vertiefung an der Verbindungsstelle vorgesehen sein, damit die Masse des zu plastifizierenden Materials sich nicht über die gesamte Dicke des Ventiltellers 31 erstreckt aber dennoch ausreicht um eine stabile Verbindung der Teile herzustellen.

Das Verschlusselement weist zudem ein auf der Dichtfläche 35 aufvulkanisiertes Dichtmaterial 36 auf. Die Dichtfläche 35 und das Dichtmaterial 36 umlaufen den Ventilteller 31 auf Seiten der Verschlussseite 34.

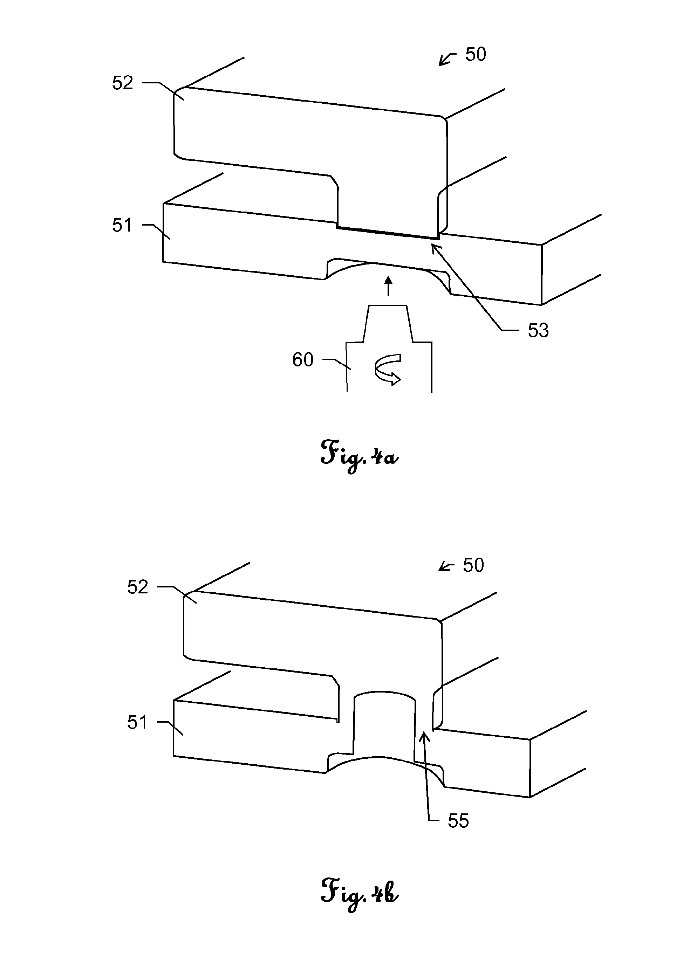

Die Figuren 4a und 4b zeigen jeweils ein Verschlusselement 50 gemäss der Erfindung einmal in einem getrennten Zustand (Fig. 4a) und in einem nach einem Reibrührscheissverbinden vorliegenden verbundenen Zustand (Fig. 4b) in einer Querschnittsansicht.

In Figur 4a wird ersichtlich wie ein Querträger 52 relativ zu einem Ventilteller 51 vor dem Verbinden dieser beiden Komponenten positioniert ist. An der Soll-Verbindungsstelle 53 ist seitens des Ventiltellers 51 an dessen Rückseite eine Vertiefung vorgesehen, in welche ein korrespondierendes Gegenstück des Querträgers passend eingreift. In anderen Worten sind das Verbindungsstück des Querträgers 52 und die Vertiefung des Ventiltellers 51 derart ausgestaltet, dass diese im Wesentlichen passgenau verbindbar sind.

Wie gezeigt wird in diesem Zustand der losen Verbindung von Ventilteller 51 und Querträger 52 ein rotierendes Reibrührschweisswerkzeug 56, beispielsweise ein Stift, in Pfeilrichtung in die Vertiefung seitens der Verschlussseite des Ventiltellers 51 bewegt. Das Werkzeug 56 wird auf die Oberfläche der Vertiefung gedrückt, wobei das Material des Ventiltellers 51 unter Wärmeentwicklung plastifiziert wird. Durch Weiterbewegen des Werkzeugs 56 in Richtung des Pfeils wird sodann auch das Material des Querträgers 52 verformbar. Die dabei andauernde Rotation des Werkzeugs 56 führt zu einer Durchmischung bzw. Verrührung der Materialen des Querträgers 52 und des Ventiltellers. Bei Erreichen eines gewünschten Plastifizierungs- und Verrührungsgrad wird die Drehbewegung des Werkzeugs 56 gestoppt und diese entgegen der Pfeilrichtung von dem Verschlusselement 50 entfernt.

Als Resultat dieses Verbindungsvorgangs ergibt sich ein Verschlusselement 50 mit einer den Querträger 52 mit dem Ventilteller 51 verbindenden Reibrührschweissverbindung 55 wie in Figur 4b dargestellt. Entgegen einer aus dem Stand der Technik bekannten Verbindung zwischen dem Querträger 52 und dem Ventilteller 51 entsteht hierbei keinerlei Verschmutzung der Verbindungsstelle, z.B. durch Abrieb, und es werden keine weiteren Materialen, wie z.B. Schweissdraht oder Schrauben, zum Herstellen der Verbindung benötigt. Eine solche Verbindung ist damit sehr gut für Anwendung im Vakuum- oder Hochvakuumbereich geeignet.

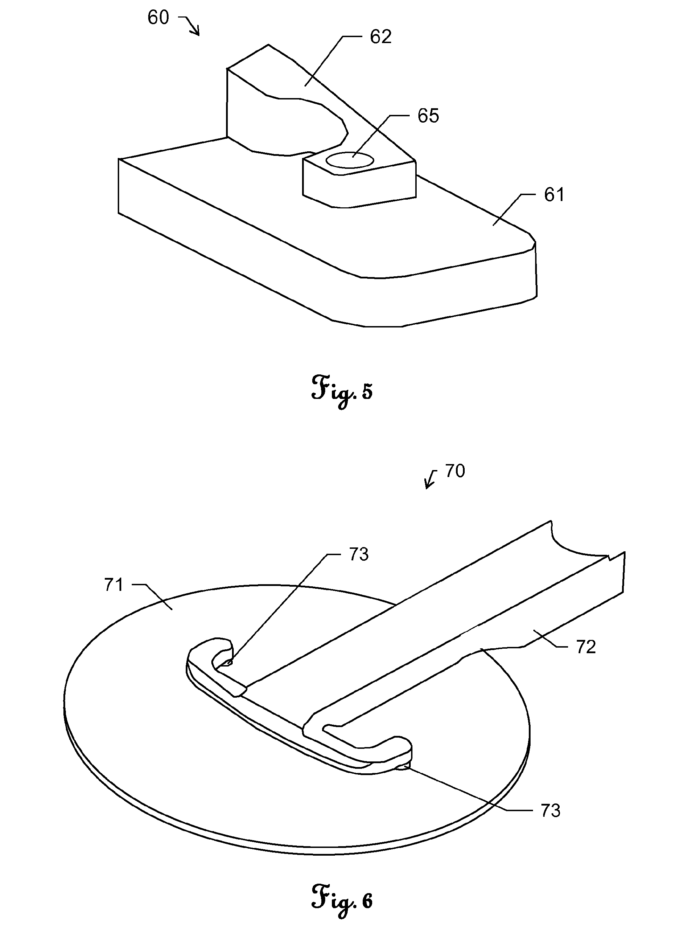

Figur 5 zeigt eine weitere Ausführungsform eines Teils eines Verschlusselements 60 gemäss der Erfindung. Die zwischen dem Querträger 62 und dem Ventilteller 61 vorliegende Reibrührschweissverbindung ist hier seitens des Querträgers 62 erzeugt. Zu sehen ist eine verbleibende Vertiefung 65 in dem Querträger 62, welche aus einem Zusammenwirken eines Reibrührschweisswerkzeugs mit der Oberseite des Querträgers resultiert.

Die Verschlussseite des Ventiltellers 61 bleibt dabei von strukturellen Oberflächenveränderungen unberührt.

Es versteht sich, dass die Erfindung nicht auf einen speziellen Typ von Vakuumventilen oder deren Verschlusselemente beschränkt ist, sondern sämtliche solche Gegenstände zum Zweck der Herstellung eine Vakuumabdichtung unabhängig von insbesondere der Form der Ventilteller oder des Antriebsmechanismus umfasst sind. So ist beispielsweise ein Verschlusselement mit einem Querträger auf einem länglich geformten Ventilteller ebenso umfasst wie ein derartiger Querträger auf einem runden Ventilteller.

Eine mögliche Befestigung einer Antriebsstange an dem Querträger kann wie bereits erwähnt mittels einer Schraube realisiert sein, jedoch alternativ auch durch ein anderes permanentes oder lösbares Fügeverfahren hergestellt sein. Auch können eine Antriebsstange und eine Querträger einstückig ausgebildet sein.

Fig. 6 zeigt eine weitere Ausführungsform eines Verschlusselements 70 mit einem auf einem Ventilteller 71 angebrachten Querträger 72 gemäss der Erfindung.

Der Querträger 72 ist dabei einstückig derart ausgebildet, dass mittels des Querträgers 72 eine direkte Anbindung an eine Antriebseinheit zur Bewegung des Ventiltellers 71 (in einem Vakuumventil) erfolgen kann. Der Querträger 72 weist somit bereits eine die Verbindung zur Antriebseinheit ermöglichende Antriebskomponente als Verlängerungselement (z.B. als Ventilstange) auf. Hierdurch kann eine zusätzliche Anbringung einer Ventilstange an den Querträger 72, z.B. mittels zusätzlicher Verschraubung, entfallen. Eine solche Quelle potentieller Verunreinigungen im Ventilsystem kann damit vermindert bzw. gänzlich vermieden werden.

Die Verbindungen 73 des Querträgers 72 mit dem Ventilteller 71 sind durch eine Reibrührschweissverbindungen wie beispielsweise mit Fig. 4b gezeigt und beschrieben realisiert. Dadurch sind auch für einen runden Ventilteller 71 wie dargestellt verunreinigende Partikelquellen im Bereich der Verbindungen 73 weitestgehend vermieden.

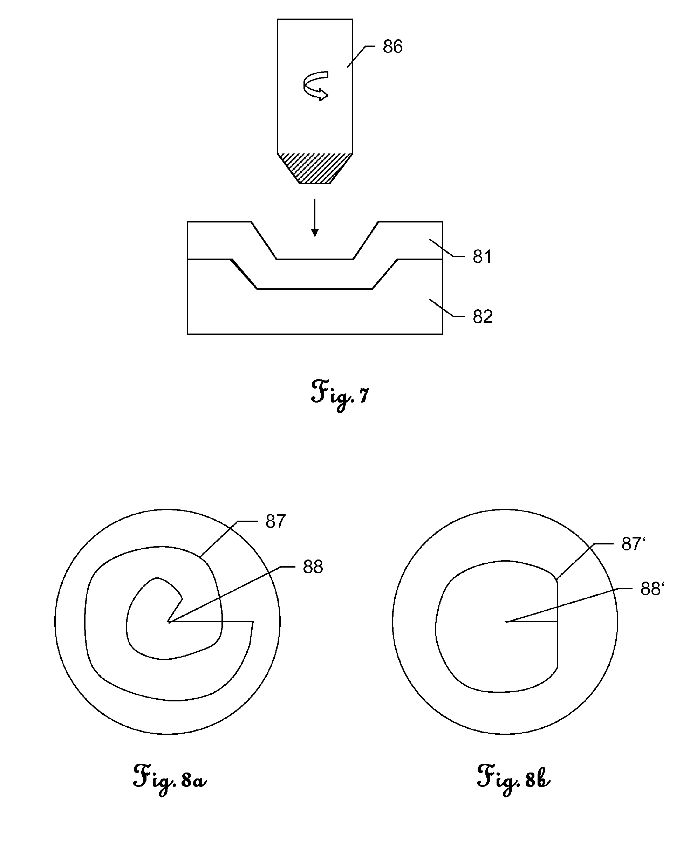

Fig. 7 zeigt ein Fügeverfahren zur Verbindung eines Ventiltellers 81 mit einem Querträger 82 gemäss der Erfindung, wie beispielsweise des mit Fig. 6 gezeigten.

Die Verbindungsstelle des Ventiltellers 81 wird mit der korrespondierenden Verbindungsstelle des Querträgers 82 in positionsmässige Übereinstimmung gebracht. An den beiden Verbindungsstellen liegt somit zunächst ein loser Kontakt der beiden Bauteile vor. Mittels eines passenden Fügewerkzeugs (nicht gezeigt) werden die beiden Teile zusammengehalten und ein eventueller Materialabfluss während des folgenden Schweissvorgangs verhindert.

Ein Stift 86 (Pin), welcher ein die Reibrührschweissverbindung herzustellendes Verbindungswerkzeug verkörpert, wird in Rotation um dessen Längsachse versetzt und in Richtung der Verbindungsstelle bewegt. Der Stift 86 weist hierbei, wie bei derartigen Schweissverfahren nach dem Stand der Technik sonst üblich, keinerlei Schulter zur Fixierung der beiden Bauteile und/oder zum Halten des plastifizierten Materials auf.

Der Stift 86 wird zunächst in den Ventilteller 81, bzw. das Material des Ventiltellers 81, an der Verbindungsstelle gedrückt. Dabei wird das Material an dieser Stelle aufgrund der resultierenden Wärmeentwicklung plastifiziert während der Stift 86 weiter in den Körper gedrückt wird.

Nach Plastifizieren und dadurch ermöglichte Durchdringen des Materials des Ventiltellers 81 wird der Stift 86 weiter in das Material des Querträgers 82 gedrückt, wodurch auch dieses Material plastifiziert wird. Durch die Rotationsbewegung des Stifts 86 erfolgt - bei Vorliegen der Materialien beider Komponenten in einem pastösen bzw. plastifizierten, d.h. plastisch verformbaren, Zustand - ein Durchmischen der Materialen und damit ein Stoffschluss.

Der Stift 86 kann hierfür entlang bestimmter Trajektorien in einer Ebene quer (z.B. orthogonal) zur Längsachse des Stiftes 86 geführt werden. Hierdurch kann eine verbesserte Vermischung der zu fügenden Materialen und/oder ein vergrösserter Fügebereich erzielt werden. Eine verbesserte Durchschweissung und damit ein homogener Materialübergang zwischen den beiden Bauteilen sind dabei vorteilhaft zu erreichen. Insbesondere kann somit eine spaltfreie Verbindung zwischen den Teilen gesichert hergestellt werden.

Solche Trajektorien 87,87' sind beispielhaft in den Figuren 8a und 8b gezeigt. Fig. 8a zeigt eine geschlossene Trajektorie 87 in Form einer Spirale. Das Zentrum des Stifts 86 wird an dem Start-/Endpunkt 88 angesetzt und unter Rotation in die Materialien gedrückt. Dann erfolgt eine Bewegung des Stifts 86 in der horizontalen Ebene entlang des gezeigten Pfades 87, wodurch eine derartige Verrührung der Materialen erfolgt, dass ein spaltfreier Materialübergang zwischen den Komponenten hergestellt wird.

Mit Fig. 8b ist ein alternativer, ebenfalls geschlossener Pfad 87' gezeigt, bei dessen Durchfahren mit dem Stift 86 eine spaltfreie Komponentenverbindung herstellbar ist.

Es versteht sich, dass die dargestellten Figuren nur mögliche Ausführungsbeispiele schematisch darstellen. Die verschiedenen Ansätze können erfindungsgemäss ebenso miteinander sowie mit Verfahren und Vorrichtungen zum Verschliessen von Prozessvolumina unter Vakuumbedingungen des Stands der Technik kombiniert werden.

## Patentansprüche

1. Verschlusselement (30,50,60,70) für ein Vakuumventil (1) mit
• einem Ventilteller (2,31,51,61,71,81) ausgebildet zum gasdichten Abschluss eines Prozessvolumens mittels Zusammenwirkens mit einer für das Prozessvolumen vorgesehenen Vakuumventilöffnung des
Vakuumventils (1), wobei der
Ventilteller (2,31,51,61,71,81)
□ eine Verschlussseite (4,34) und eine hierzu im Wesentlichen parallel gegenüberliegenden Rückseite (3,33) und
□ eine der Verschlussseite (4,34) zugeordnete und zu einer zweiten Dichtfläche der Vakuumventilöffnung, insbesondere hinsichtlich Form und Grösse, korrespondierende erste Dichtfläche (35), insbesondere mit aufvulkanisiertem Dichtmaterial (36), wobei die zweite Dichtfläche die Vakuumventilöffnung umläuft,
aufweist, und
• einem Querträger (20,40,52,62,72,82), insbesondere mit einer Aufnahme (21) für eine Antriebskomponente quer zu einer Erstreckungsrichtung des Querträgers, wobei der Querträger (20,40,52,62,72,82) an der Rückseite (3,33) des Ventiltellers (2,31,51,61,71,81) an zumindest einer Verbindungsstelle (23,32,53,73) mit dem Ventilteller (2,31,51,61,71,81) verbunden ist,
**dadurch gekennzeichnet, dass**
• die Verbindung des Querträgers (20,40,52,62,72,82) mit dem Ventilteller (2,31,51,61,71,81) an der zumindest einen Verbindungsstelle (23,32,53,73) eine Reibrührschweissverbindung (55) aufweist.

2. Verschlusselement (30,50,60,70) nach Anspruch 1,
**dadurch gekennzeichnet, dass**
der Querträger (20,40,52,62,72,82) an zwei Verbindungsstellen (23,32,53,73) mit der Rückseite des Ventiltellers (2,31,51,61,71,81) verbunden ist, wobei die zwei Verbindungen mittels jeweils einer Reibrührschweissverbindung (55) ausgebildet sind.

3. Verschlusselement (30,50,60,70) nach Anspruch 2,
**dadurch gekennzeichnet, dass**
die Aufnahme (21) mittig an dem
Querträger (20,40,52,62) angeordnet oder ausgeformt ist und die zwei Verbindungsstellen (23,32,53) beidseitig relativ zu der Aufnahme (21) liegend angeordnet sind.

4. Verschlusselement (30,50,60,70) nach einem der Ansprüche 1 bis 3,
**dadurch gekennzeichnet, dass**
der Querträger (20,40,52,62,72,82) an der mindestens einen Verbindungsstelle (23,32,53,73) eine Vertiefung aufweist, die sich im Wesentlichen parallel zu einer Achse erstreckt, die orthogonal zu einer durch die Form und/oder Oberfläche der Rückseite (3,33) oder der Verschlussseite (4,34) definierten Ebene steht.

5. Verschlusselement (30,50,60,70) nach einem der Ansprüche 1 bis 3,
**dadurch gekennzeichnet, dass**
der Ventilteller (2,31,51,61,71,81) eine der mindestens einen Verbindungsstelle (23,32,53,73) zugeordnete Vertiefung auf der Verschlussseite (4,34) aufweist, wobei sich die Vertiefung im Wesentlichen parallel zu einer Achse erstreckt, die orthogonal zu einer durch die Form und/oder Oberfläche der Rückseite (3,33) oder der Verschlussseite (4,34) definierten Ebene steht.

6. Verschlusselement (30,50,60,70) nach Anspruch 4 oder 5, **dadurch gekennzeichnet, dass**
die Vertiefung sich über eine definierte Tiefe in Richtung der Achse erstreckt, wobei die Tiefe grösser ist als eine Materialdicke des
Querträgers (20,40,52,62,72,82) bzw. des Ventiltellers (2,31,51,61,71,81) an der Verbindungsstelle (23,32,53,73).

7. Verschlusselement (30,50,60,70) nach einem der Ansprüche 4 bis 6,
**dadurch gekennzeichnet, dass**
die Vertiefung des Querträgers (20,40,52,62,72,82) derart ausgeformt ist, dass die Vertiefung sich durch den Querträger (20,40,52,62,72,82) hindurch erstreckt und in den Ventilteller (2,31,51,61,71,81) hinein ragt.

8. Verschlusselement (30,50,60,70) nach einem der Ansprüche 4 bis 6,
**dadurch gekennzeichnet, dass**
die Vertiefung des Ventiltellers (2,31,51,61,71,81) derart ausgeformt ist, dass die Vertiefung sich durch den Ventilteller (2,31,51,61,71,81) hindurch erstreckt und in den Querträger (20,40,52,62,72,82) hinein ragt.

9. Verschlusselement (30,50,60,70) nach einem der Ansprüche 1 bis 8,
**dadurch gekennzeichnet, dass**
an der Verbindungsstelle (23,32,53,73) in einem Übergangsbereich ein durch zeitweises Plastifizieren der Materialien des Querträgers (20,40,52,62,72,82) und des Ventiltellers (2,31,51,61,71,81) erzeugter Stoffschluss vorliegt, wobei der Übergangsbereich durch einen sich entlang der Achse über einen Kontaktpunkt des Querträgers (20,40,52,62,72,82) mit dem Ventilteller (2,31,51,61,71,81) erstreckenden Abschnitt an der Verbindungsstelle (23,32,53,73) definiert ist.

10. Verschlusselement (30,50,60,70) nach einem der Ansprüche 1 bis 9,
**dadurch gekennzeichnet, dass**
die Reibrührschweissverbindung (55) einen homogenen Materialübergang zwischen dem
Ventilteller (2,31,51,61,71,81) und dem Querträger (20,40,52,62,72,82) verkörpert, insbesondere wobei eine spaltfreie Verbindung (55) vorliegt.

11. Vakuumventil (1) zum gasdichten Abschluss eines Prozessvolumens, mit
• einem Ventilgehäuse, das eine Vakuumventilöffnung und einen die Vakuumventilöffnung umlaufenden eine zweite Dichtfläche aufweisenden Ventilsitz aufweist,
• einem Ventilteller (2,31,51,61,71,81) zum im Wesentlichen gasdichten Verschliessen der Vakuumventilöffnung mit einer ersten zu der zweiten Dichtfläche korrespondierenden Dichtfläche,
• einem Querträger (20,40,52,62,72,82), insbesondere mit einer Aufnahme für eine Antriebskomponente quer zu einer Erstreckungsrichtung des Querträgers (20,40,52,62,72,82), wobei der Querträger an einer Rückseite (3,33) des
Ventiltellers (2,31,51,61,71,81) an zumindest einer Verbindungsstelle (23,32,53,73) mit dem Ventilteller (2,31,51,61,71,81) verbunden ist,
• einer mit dem Querträger (20,40,52,62,72,82), insbesondere vermittels der Aufnahme, gekoppelten Antriebseinheit, die derart ausgebildet ist, dass der Ventilteller (2,31,51,61,71,81) von
□ einer Offenposition, in welcher der Ventilteller die Vakuumventilöffnung freigibt, in
□ eine Schliessposition, in welcher die erste Dichtfläche des Ventiltellers (2,31,51,61,71,81) auf die zweite Dichtfläche angedrückt ist und die Vakuumventilöffnung im Wesentlichen gasdicht verschliesst,
und zurück verstellbar ist, insbesondere zumindest im Wesentlichen entlang einer geometrischen Längsachse in eine Längsschliessrichtung,
□ insbesondere durch eine Beweglichkeit des Ventiltellers (2,31,51,61,71,81) im Wesentlichen entlang einer rechtwinklig zur Längsachse verlaufenden geometrischen Querachse in eine Querschliessrichtung in eine Zwischenposition, in welcher der Ventilteller (2,31,51,61,71,81) die Vakuumventilöffnung überdeckt und sich eine Verschlussseite des Ventiltellers in einer beabstandeten Gegenüberlage zum Ventilsitz befindet, und zurück verstellbar ist,
**dadurch gekennzeichnet, dass**
die Verbindung des Querträgers (20,40,52,62,72,82) mit dem Ventilteller (2,31,51,61,71,81) an der zumindest einen Verbindungsstelle (23,32,53,73) eine Reibrührschweissverbindung (55) aufweist, insbesondere wobei ein den
Ventilteller (2,31,51,61,71,81) und den Querträger (20,40,52,62,72,82) aufweisendes Verschlusselement (30,50,60,70) nach einem der Ansprüche 1 bis 10 ausgebildet ist.

12. Verfahren zur Herstellung eines
Verschlusselements (30,50,60,70) mit einem Querträger (20,40,52,62,72,82) für ein Vakuumventil, mit
• einem körperlichen ersten Teil und
• einem körperlichen zweiten Teil,
wobei das erste Teil und das zweite Teil einen Ventilteller (2,31,51,61,71,81) und den Querträger (20,40,52,62,72,82) verkörpern und wobei
• ein Fügewerkzeug mit dem ersten und dem zweiten Teil bestückt wird,
• das bestückte Fügewerkzeug in eine Fügemaschine, insbesondere in eine Schweissmaschine, insbesondere Reibrührschweissmaschine, eingebracht wird, und
• durch Zusammenwirken der Fügemaschine mit dem ersten und zweiten Teil eine Reibrührschweissverbindung des Querträgers (20,40,52,62,72,82) mit dem Ventilteller (2,31,51,61,71,81) hergestellt wird.

13. Verfahren nach Anspruch 12,
**dadurch gekennzeichnet, dass**
• die Fügemaschine ein Verbindungswerkzeug (56,86), insbesondere einen aus einer Schulter herausragenden Stift (56), aufweist,
• das Verbindungswerkzeug (56,86) mittels der Fügemaschine in Rotation um eine lineare Bewegungsachse versetzt wird, insbesondere konzentrisch um eine Längsachse des Verbindungswerkzeugs (56,86), und
• das rotierende Verbindungswerkzeug (56,86) entlang der Bewegungsachse derart tief in das erste Teil gedrückt wird, dass
□ das Verbindungswerkzeug (56,86) das erste Teil hinsichtlich dessen Dicke in Richtung der Bewegungsachse durchdringt und
□ das Verbindungswerkzeug (56,86) in den Körper des zweiten Teils eindringt.

14. Verfahren nach Anspruch 13,
**dadurch gekennzeichnet, dass**
das Verbindungswerkzeug (56,86) in einem plastisch verformbaren Zustand des Materials des ersten Teils und des Materials des zweiten Teils orthogonal zur Bewegungsachse entlang einer definierten Trajektorie (87,87') geführt wird, insbesondere kreisförmig oder spiralförmig in einer Ebene orthogonal zur Bewegungsachse.

15. Verschlusselement (30,50,60,70) erhalten durch Ausführung eines Verfahrens nach einem der Ansprüche 12 bis 14, insbesondere wobei ein
Verschlusselement (30,50,60) gemäss einem der Ansprüche 1 bis 11 erzeugt ist.
